Europäisches Patentamt

European Patent Office

Office européen des brevets

(19)

(11) EP 1 349 204 A2

## (12) EUROPEAN PATENT APPLICATION

(43) Date of publication:
01.10.2003 Bulletin 2003/40

(51) Int Cl.7: H01L 21/20, C30B 23/02, H01L 21/762

(21) Application number: 03447043.5

(22) Date of filing: 28.02.2003

(84) Designated Contracting States:
AT BE BG CH CY CZ DE DK EE ES FI FR GB GR
HU IE IT LI LU MC NL PT SE SI SK TR
Designated Extension States:
AL LT LV MK RO

(30) Priority: 28.02.2002 EP 02447031
22.03.2002 US 367026 P

(71) Applicants:
• INTERUNIVERSITAIR MICROELEKTRONICA
CENTRUM ( IMEC)
3001 Leuven (BE)

• Umicore S.A.
1000 Brussels (BE)

(72) Inventors:
• Flamand, Giovanni
2110 Wijnegem (BE)
• Poortmans, Jef
3010 Kessel-Lo (BE)

(74) Representative: Van Malderen, Joelle et al
Office Van Malderen,
Place Reine Fabiola 6/1
1083 Bruxelles (BE)

(54) **A method for producing a device having a semiconductor layer on a lattice mismatched substrate**

(57) The present invention is related to a layer stack comprising a monocrystalline layer located upon a porous surface of a substrate, said monocrystalline layer and said substrate being significantly lattice mismatched, obtainable by a process comprising a sublimation or an evaporation step by emission from a source and an incomplete filling step of said porous surface by said sublimated or evaporated emission.

Fig. 1

EP 1 349 204 A2

## Description

## Field of the invention

The present invention is related to a semiconductor device comprising a dislocation-free monocrystalline (epitaxial layer) on a substrate when a significant lattice mismatch exists between said substrate and said monocrystalline layer. The present invention equally relates to a method for growing said dislocation-free monocrystalline layer on top of said substrate.

## State of the art

In a large variety of semiconductor devices, it is desirable to have a monocrystalline layer stack of lattice mismatched materials. For example, the hetero-epitaxial growth of different types of semiconductor film such as Ge, $Ge_xSi_{1-x}$ or Group III-V semiconductor such as GaAs on a Si substrate could allow the monolithic integration of particular functional devices e.g. optical detectors, laser, light-emitting diodes (LEDs) or high speed transistor with Si ultra large scale integrated circuits. Alternatively the epitaxial growth of highband gap semiconductors on the most common substrates such as Si substrates could lead to a cheaper, high volume realisation of short wavelength diode lasers (yellow, green, blue and ultraviolet) or multi-junction monolithic cascade solar cells.

For many years attempts have been made to grow various epitaxial layers on significantly lattice mismatched substrates by conventional techniques such as chemical vapour deposition (CVD) or molecular beam epitaxy (MBE). By 'significantly lattice mismatched' it is meant that the substrate and the epitaxial layer differ in their lattice constants by at least 0.3%, preferably 0.5%. In the text, the words epitaxial and monocrystalline are used as synonyms.

In the case of CVD, it is not easy to realise high conversion efficiency from gaseous precursors to the desired semiconductor layer on the substrate without negatively affecting uniformity. In the case of MBE, the yield is higher but the complexity of the associated equipment is large. The resulting epitaxial layers always contain a large number of defects because of the difference in lattice constant and thermal expansion coefficient between the host substrate and the grown crystal. Documents US-A-4 806 996 and US-A-5 981 400 describe a method for overcoming significant lattice mismatches, which consists in making the base material porous at the top surface or in patterning the top surface of the base layer before growing the other material by conventional techniques.

M.T. Currie et al. in App. Phys. Lett. volume 72, number 14, page 1718, describes a method to grow epitaxial Ge on Si which uses a graded Si/Ge buffer layer deposited by ultra high vacuum chemical vapour deposition (UHVCVD). However the method is complex and expensive. The fact that no commercial devices have appeared on the market gives an indication that none of the method described in the mentioned prior art leads to the growth of high quality layer, with high degree of crystallinity. It is known that the desirable properties of a layer are usually enhanced by the degree of crystallinity of the layer itself. For instance, the electron mobility and the band gap value are directly related to the crystallinity of the semiconductor layer. Therefore the high quality of the grown crystal is a fundamental requirement for fabricating working devices.

Finally, US-B-6,331,208 describes a crystal silicon substrate anodised to form a porous layer thereon and a thin-film crystal grown by epitaxial growth on said porous layer. Openings extending from the surface of the grown crystal and reaching the porous layer are provided by applying laser beams, and the porous layer is selectively etched through the openings to separate the thin-film crystal from the substrate. The thin-film crystal separated is transferred to another supporting substrate to form a solar cell

## Aims of the invention

The present invention aims to provide a device in the form of a layer stack which does not have the drawbacks of the state of the art.

Furthermore, the present invention aims to provide a method for producing such a device.

More particularly, the present invention aims to provide a dislocation-free monocrystalline layer on a substrate when significant lattice mismatch exists between said substrate and said monocrystalline layer.

The present invention equally aims to provide a simple method to grow said dislocation-free monocrystalline layer on top of said substrate.

## Summary of the invention

According to a first aspect, the present invention is related to a device in the form of a layer stack comprising a dislocation-free monocrystalline layer located upon the porous top surface of a substrate, said monocrystalline layer and said substrate being significantly lattice mismatched and wherein said porous surface is partially filled with sublimated or evaporated material, said device is obtained by the method described hereunder.

According to a second aspect, the present invention is related to a method for producing a device in the form of a layer stack comprising a dislocation-free monocrystalline layer located upon the porous surface of a substrate, said monocrystalline layer and said substrate being significantly lattice mismatched. Significantly lattice mismatched means a difference in lattice constants between the substrate and the monocrystalline layer comprised preferably between 0.5 and 10 %, preferably between 0.5 and 8%, between 1 and 6% and preferably about 4 %. In particular said method comprises a step of growing said dislocation-free monocrystalline layer. Before said step a sublimation or an evaporation step of material from a source is performed and an incomplete or partial filling of said porous surface of said substrate by said sublimated or evaporated material is obtained. Said sublimation or evaporation step and said filling step are accompanied by a chemical reaction of the material form the source. In a first step, the source material is oxidized and in a second step, the oxidized material is reduced while being deposited into the pores of the substrate.

Compared to MBE, the method of the present invention allows higher deposition rates. Moreover, the method of the present invention does not have to performed at high vacuum, which requires complicated equipement. Consequently, the method of the present invention is cheaper.

In a preferred embodiment, the dislocation free monocrystalline layer located on the porous surface of said substrate is obtained by close space vapour transport (CSVT) process.

Another aspect of the present invention is to provide a method for producing a free standing device in the form of a layer stack, comprising a dislocation-free monocrystalline layer located upon a porous surface of a substrate, said monocrystalline layer and said substrate being significantly lattice mismatched. In particular said method comprises a step of growing said dislocation free monocrystalline layer. Before said step, a sublimation or an evaporation step of material from a source is performed and an incomplete or partial filling of said porous surface of said substrate by said sublimated or said evapored material is obtained.

According to a further aspect, the present invention is also related to the free standing device in the form of a layer stack comprising a dislocation-free monocrystalline layer located upon a porous surface of a substrate, said monocrystalline layer and said substrate being significantly lattice mismatched, wherein said porous surface is partially filled with sublimated or evaporated material, said device being obtainable by the method described hereabove.

Said device obtained by the method described hereabove can be made free standing from the substrate by a lift-off process.

By free standing it should be understood a device which is able to support itself after being submitted to a deformation.

In a preferred embodiment, the dislocation free monocrystalline layer located on the porous surface of said substrate is obtained by close space vapour transport (CSVT) process.

Preferably, the monocrystalline layer is essentially germanium and the substrate is essentially silicon.

The devices in the form of layer stacks described hereabove may be used for semiconductor applications such as optical detectors, laser, light-emitting diodes or high-speed transistor.

## Short description of the drawings

Fig. 1 represents represents the schematic set-up used for the deposition of epitaxial Ge onto a porous surface of a Si wafer according to the first embodiment.

Fig. 2 represents the Si porous surface partially filled with sublimated or evaporated Ge.

Fig. 3 represents the schematic set-up used for the deposition of epitaxial Ge onto a porous surface of a Si wafer according to the second embodiment.

Fig. 4 represents the XRD pattern of epitaxial Ge layer grown onto a porous surface of a Si wafer.

Fig. 5 represents the schematic set-up used for the deposition of epitaxial Ge onto a porous surface of a Si wafer according to the third embodiment.

## Detailed description of the preferred embodiments of the invention

The present invention is related to a method for producing a device in the form of a layer stack comprising a dislocation-free monocrystalline layer located upon the porous surface of a substrate, said monocrystalline layer and said substrate being significantly lattice mismatched. Said porous layer may have a porosity profile of the type lower/higher/lower or higher/lower and the porosity may vary between 10% and 80 and preferably between 20 and 70%. The thickness of said porous layer may range between 20 nm and 50 $\mu$m, between 100 nm and 50 $\mu$m, between 1 $\mu$m and 50 $\mu$m , between 5 $\mu$m and 20 $\mu$m. . Significantly lattice mismatched meaning a difference in lattice constants between the substrate and the monocrystalline layer between 0.5 and 10 %, between 0.5 and 8%, between 1 and 6% and preferably about 4 %. In particular said method comprises a step of growing said dislocation-free monocrystalline layer. In particular said method comprises a step of growing said dislocation free monocrystalline layer. Before said step a sublimation or an evaporation step of material from a source is performed and an incomplete or partial filling of said porous surface of said substrate by said sublimated or evaporated material is obtained. Said sublimation or evaporation step and said filling step are accompanied by a chemical reaction of the material form the source. In a first step, the source material is oxidized and in a second step, the oxidized material is reduced while being deposited into the pores of the substrate. The sublimation or evaporation step are performed in an atmosphere comprising an oxidizing agent such as e.g. water vapour or the like. The chemical reaction between the source X and the oxidizing agent is

$$X + H_2O \rightarrow X\text{-oxide} + H_2$$

This reaction is driven by the temperature, higher temperature force the reaction to the oxidized form of the source material. The temperature of the source material depends on the characteristics of the source material. The temperature should be such that an evaporation or sublimation of the source material can occur.

In a second step, the oxidized source material is reduced while being deposited on the porous substrate such that a monocrystalline layer is formed. The monocrystalline layer comprises at least the source material.

$$X\text{-oxide} \rightarrow X$$

The oxidation and reduction are driven by the temperature difference between the source material and the porous substrate. The source material should be at higher temperature than the porous substrate. The temperature difference between the source material and the porous substrate is between 10 and 150 degrees C, between 20 and 150 degrees C, between 20 and 100 degrees C, between 40 and 70 degrees C, preferably 50 or 60 degrees C.

The distance between the source material and the porous substrate is between 0.01 cm and 1 cm, between 0.01 m and 0.5 cm, between 0.01 cm and 0.1 cm, preferably 0.2 cm, 0.3cm, 0.1 cm or 0.05 cm.

The method is performed at a pressure in the range $10^{-3}$ atm and 1 atm, between $10^{-2}$ atm and 1 atm, between $10^{-1}$ atm and 1 atm, between 0.2 and 1 atm. The pressure can be about 0.4 atm, 0.5 atm or 0.6 atm. Compared to MBE, which requires very high vaccum, the method of the present invention is performed at higher pressure.

The monocrystalline layer comprises the source material. The source material can be any semiconducting material. The semidconducting material can be a group III material, a group IV material or a group V material. The source material can comprise a material selected from the group Si, Ge, Ga, As, In, Se, Cu, Al, Tl, Sn, Pb, B, P, Sb, Bi and compounds thereof. Preferably, said source material is Germanium. Preferably, the monocrystalline layer consists essentially of germanium. The substrate is a substrate having pores. Said substrate can be made of semiconducting material. Said semiconducting material can be an inorganic semiconducting material or an organic semiconducting material. Preferably, the substrate is essentially silicon.

Said porous layer may have a porosity profile of the type lower/higher/lower or higher/lower and the porosity may vary between 20 and 70%. The thickness of said porous layer is higher than 50 nm, higher than 100 nm and preferably higher than 1 μm. The thickness may range between 100 nm and 50 μm, between 100 nm and 20 μm, between 1 μm and 10 μm. Preferably, the thickness is about 2 μm, about 3 μm, about 4 μm.

The resulting monocrystalline layer should have a thickness being sufficient to allow polishing of the layer. The thickness is between 1 μm and 50 μm, preferably between 5 μm and 20 μm.

In an aspect of the present invention, a dislocation-free monocrystalline layer is grown onto a significant lattice mismatched substrate by the methods illustrates in the following embodiments.

In a first embodiment, a dislocation-free epitaxial Ge layer is grown onto the top surface of a Si substrate. A lattice mismatch of about 4% exists between the Si substrate and the Ge layer. Therefore a porous layer is first formed at the surface of the Si substrate. Said forming step of a porous layer may be done by an anodization technique or according to any other method known by a person skilled in the art. Said porous layer may have a porosity profile of the type lower/higher/lower or higher/lower and the porosity may vary between 20 and 70%. The thickness of said porous layer is higher than 50 nm, higher than 100 nm and preferably higher than 1 μm. The thickness may range between 100 nm and 50 μm, between 100 nm and 20 μm, between 1 μm and 10 μm. Preferably, the thickness is about 2 μm, about 3 μm, about 4 μm.

The Ge material is then sublimated from a Ge source. The Germanium source can be in the solid phase or can be in the liquid phase.

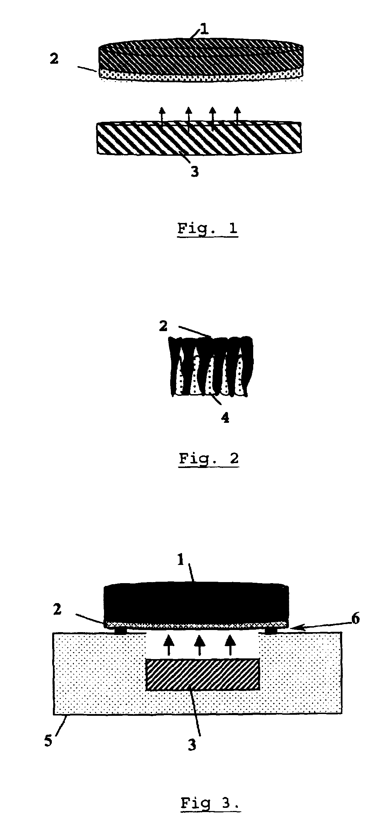

Figure 1 illustrates the schematic experimental set-up employed in the first embodiment.

A wafer consisting in a Si substrate(1) having a porous Si layer (2) is placed in said set-up and a Ge wafer (3) serves as a Ge source for the sublimated or evaporated material.

Both wafers are placed opposite to each other, separated only by a few hundreds μm thick spacer (not shown). When the system is brought to a temperature ranging from 700 to 930°C under an $H_2$-atmosphere, sublimation of Ge occurs. The Si pores start to be filled with sublimated Ge material(4) the filling is a function of time. After 1 hour for example, Si pores are filled with Ge to a depth of about 600 nm. According to Rutherford backscattering (RBS) analysis, 30% Ge is present at the Si/porous Si substrate when the surface porosity is about 30%, and the Ge content linearly decreases over the depth and an empty space is still present underneath such a Si/Ge graded layer as shown in Figure 2.

In a second embodiment a dislocation free epitaxial Ge layer is grown onto a Si substrate by forming a porous layer at the surface of the Si substrate as described in the first embodiment, followed by the sublimation of Ge onto the porous Si at a temperature of between 950 and 1000°C under an $H_2$-atmosphere.

In this case, the Si(1)/porous Si(2) wafer is placed over a graphite susceptor (5) only separated from it by thin spacers (6) as shown in Figure 3.

The first wafer consists in a Si substrate (1) on which a porous Si layer (2) is created. A second wafer which is a bulk Ge wafer(3) is placed as a source of evaporated material in a cavity of the graphite susceptor. At 936°C, Ge melts, starts to evaporate and diffuses
into the pores in the Si wafer. The distance between the
bulk Ge wafer and the Si wafer is approximately 1 cm.
The Si pores start filling with evaporated Ge (4) and the
filling is function of time. For example, after 1 hour Si
pores are filled with Ge to a depth of about 600 nm. According to Rutherford backscattering (RBS) analysis,
30% Ge is present at the Si/porous Si substrate when
the surface porosity is about 30%, and the Ge content
linearly decreases over the depth and an empty space
is present underneath such a Si/Ge graded layer as
shown in Figure 2.

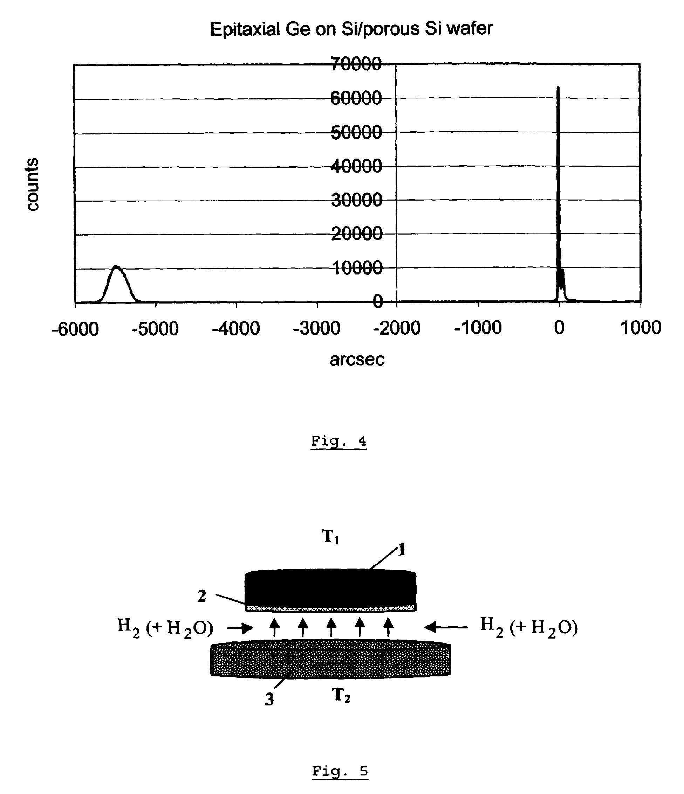

In both first and second embodiments, dislocation-free epitaxial Ge is grown on top of the obtained
graded Si/Ge layer by plasma enhanced CVD technique
to the desired thickness. The fact that the Ge is epitaxial
is evidenced by the XRD analysis shown in Figure 4. At
0 arcsec two peaks are observed, one from the Si-wafer
and one from the porous Si layer. At -5500 arcsec there
is a peak belonging to the Ge layer grown on top. Any
other growth technique such as UHCVD, metal organic
chemical vapour deposition (MOCVD), MBE, could be
successfully employed to grow epitaxial Ge after the formation of the Si/Ge graded layer by sublimation. In fact,
the stress related to the growth of epitaxial Ge is largely
relieved by the presence of empty pores underneath the
Si/Ge graded layer.

In a third embodiment of the present invention,
a porous layer is first formed at the surface of the Si
substrate as described in the first embodiment. Dislocation-free epitaxial Ge of the desired thickness on the wafer consisting in Si substrate(1) on which porous Si(2)
layer is then grown in one step by a close space vapour
transport (CSVT) process as schematically shown in
Figure 5.

The CSVT technique relies on the temperature
difference between the sublimation source and the receiving substrate. In the present enbodiment, the Ge
source (3) is placed at a distance of a few tenths of mm
from the Si(1)/porous Si(2) wafer. The temperature ($T_1$)
of the Si/porous Si substrate is always kept hundreds of
degrees lower that the temperature ($T_2$) of the Ge
source. The experiments are performed in $H_2$ atmos-
phere, with the addition of water vapour . When $T_2$ is
high enough at the desired pressure, Ge starts to sublimate. Ge (4) first diffuses in the Si pores of the Si(1)/
porous Si(2) substrate, after that epitaxial Ge starts to
grow on top of the Si/Ge graded layer.

It should be emphasised that in spite of the fact
that CSVT process is not recognised as a conventional
technique by the IC world, it has a lot of advantages.
CSVT has a high yield, is relatively simple if compared
to CVD or MBE techniques, and does not require vacuum. In addition, CSVT process can be applied on large
scale and is therefore interesting for industrial use.

According to another aspect of the present invention, a device in the form of layer stack comprising a dislocation-free monocrystalline layer located upon a
porous surface of a substrate is obtained, the monocrystalline layer and the substrate being significantly lattice mismatched. Such a device is advantageously obtained by the CSVT technique or by any of the techniques described above which in first instance fill the
pores of the porous Si by sublimation or evaporation of
material from a source.

Preferably, the substrate is Si because it is
available in large sizes (>8 inch) with a high degree of
crystallography (very low defect density < 1 cm$^{-2}$) and
mechanical perfection. Moreover, it features a high mechanical strength and a thermal conductivity several
times higher than many other semiconductors. However, other semiconductor substrates could serve the
scope. Analogously, other materials than Ge, selected
from the group III-V semiconductor such as GaAs could
be grown as dislocation-free monocrystalline layers on
a Si substrate. An additional aspect of the present invention discloses a free-standing device in the form of
a layer stack made of a dislocation-free monocrystalline
layer onto a porous carrier. Said free standing layer
stack can be obtained by a lift-off process. For example,
the graded Si/Ge layer formed at the interface between
porous Si and Ge, according to the previous embodiments described above, can be lifted off from the Si-substrate to realise a free-standing Ge-film partially filled Si-
carrier. Said Si carrier provides the necessary mechanical strength for the Ge-film and acts as a complying substrate for the Ge film resulting in a material with lower
defect density. Said lift-off of the Si/Ge layer can be done
either mechanically or by wet chemistry or if the porosity
profile in partially filled Si layer is large enough even
spontaneously.

This proves that this technique can be used to
realise free-standing, porous Si/Ge templates (5) as illustrated in Figure 5.

The realisation of dislocation-free Ge epitaxial
layer on Si substrate could serve as starting platform for
the growth of GaAs and/or AlGaAs for the realisation of
reliable low-cost GaAs-based optical, electronic or optoelectronic devices and could pave the way to monolithic integration of silicon and compound semiconductor
devices.

**Claims**

1.  A device in the form of a layer stack comprising a
    dislocation-free monocrystalline layer located upon
    the porous surface (2) of a substrate (1), said
    monocrystalline layer and said substrate being significantly lattice mismatched, said device being obtainable by a method of forming said device comprising a sublimation step or an evaporation step of
    material from a source(3), wherein said source material is oxidized and an incomplete or partial filling
    step of said porous surface (2) of said substrate by said sublimated or evaporated material, wherein said oxidized source material is reduced before the step of growing the dislocation-free monocrystalline layer.

2. A device as in claim 1, wherein the monocrystalline layer is germanium and the substrate is silicon.

3. A device as in claim 1 or 2, wherein said monocrystalline layer is obtainable by a close space vapour transport process.

4. A free standing device in the form of a layer stack comprising a dislocation-free monocrystalline layer located upon the porous surface (2) of a substrate (1), said monocrystalline layer and said substrate being significantly lattice mismatched, said device being obtainable by a method of forming said device comprising a sublimation step or an evaporation step of material from a source (3) and an incomplete or partial filling step of said porous surface (2) of said substrate by said sublimated or evaporated material before the step of growing the dislocation-free monocrystalline layer.

5. A free standing device as in claim 4, wherein the monocrystalline layer is germanium and the substrate is silicon.

6. A free standing device as in claim 4 or 5, wherein said monocrystalline 10ayer is obtainable by a close space vapour transport process.

7. A method for producing a device, said device comprising comprising a dislocation-free monocrystalline layer located upon a porous surface on a substrate, said monocrystalline layer and said substrate being significantly lattice mismatched, said method comprising the steps of:

   - providing said substrate, said substrate having a porous layer on the surface of said substrate;
   - sublimating or evaporating material from a source, thereby oxidizing said source material;
   - filling partially or incompletely said porous surface of said substrate by said sublimated or evaporated material, thereby reducing said oxidized source material.

8. The method as in claim 7 further comprising the step of growing the dislocation-free monocrystalline layer on said substrate.

9. A method as recited in claim 7 wherein the distance between said source and said porous layer of said substrate is between 0.01 cm and 1 cm.

10. A method as recited in claim 7 wherein said method is performed at a pressure higher than $10^{-3}$ atmosphere.

11. A method as recited in claim 7 wherein the temperature of said source material is higher than the temperature of said substrate.

12. A method as recited in claim 7 said wherein the monocrystalline layer is grown by close space vapour transport process.

13. A method as in claim 7 or 8 wherein said layer stack is lifted of from said substrate.

14. Method as in claim 7, wherein the source material comprises germanium and the porous surface comprises silicon.

15. Use of a layer stack as in any of the previous claims to 6 for semiconductor applications such as optical detectors, laser, light-emitting diodes or high-speed transistor.

Fig. 1

Fig. 2

Fig 3.

## Epitaxial Ge on Si/porous Si wafer

Fig. 4

Fig. 5